(19) **Europäisches Patentamt**

**European Patent Office**

**Office européen des brevets**

(11) **EP 1 225 689 A2**

(12) **EUROPEAN PATENT APPLICATION**

(43) Date of publication:
**24.07.2002 Bulletin 2002/30**

(51) Int Cl.⁷: **H03B 5/12**

(21) Application number: **02250050.8**

(22) Date of filing: **04.01.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **05.01.2001 JP 2001000604**

(71) Applicant: **TDK Corporation**
**Chuo-ku, Tokyo (JP)**

(72) Inventors:
• **Nishiyama, Tetsuya, c/o TDK Corporation**
**Tokyo (JP)**
• **Kobayashi, Hiroshi, c/o TDK Corporation**
**Tokyo (JP)**

(74) Representative: **Billington, Lawrence Emlyn et al**
**Haseltine Lake & Co.,**
**Imperial House,**
**15-19 Kingsway**
**London WC2B 6UD (GB)**

(54) **Oscillation circuit with voltage-controlled oscillators**

(57)    An oscillation circuit including first and second voltage-controlled oscillators (VC01, VC02) each having a resonance circuit including a pair of varactor diodes (61, 62, 71, 72), and first and second buffer amplifiers (BAMP1, BAMP2) for feeding-back high frequency signals generated from the first and second voltage-controlled oscillators (VC01, VC02) to the second and first voltage-controlled oscillators (VC02, VC01), respectively. A control voltage (Vc) is applied to the varactor diodes (61, 62, 71, 72) to generate output high fre-

quency signals having a same frequency and a mutual phase difference of 90 degrees from the first and second voltage-controlled oscillators (VC01, VC02). By adjusting an amplitude of the control voltage (Vc), resonant points of the resonance circuits of the first and second voltage-controlled oscillators (VC01, VC02) are changed and the frequency of the output high frequency signals is changed, while phase noise can be sufficiently suppressed over a wide frequency range and a power consumption can be lowered.

*FIG. 3*

## Description

The present invention relates to an oscillation circuit for generating at least two high frequency signals having a same frequency and a predetermined mutual phase difference, and more particularly to a quadrature oscillation circuit for generating two high frequency signals having a same frequency and a mutual phase difference of 90 degrees.

There have been proposed various types of the oscillation circuits mentioned in the preamble. Among these oscillation circuits, there has been proposed a quadrature oscillation circuit, in which first and second voltage-controlled oscillators each having a negative mutual conductance are coupled with each other in a ring-shape by means of first and second buffer amplifiers each having a transconductance.

Such a quadrature oscillation circuit is described in various publications such as ISSCC99/SESSION23/WP23.7, "A 6.5 GHz Monolithic CMOS Voltage-Controlled Oscillator", Ting-Ping Liu, Bell Labs., Lucent Technologies, Holmdel, NJ, U.S.A. and ISSCC97/SESSIONS/COMMUNICATION BUILDING BLOCJESI/TP5.6, "A 0:9-2.2 GHz Monolithic Qaudrature Mixers, Oscillator for Direct-Conversion satellite Receivers", Johan van der Tang, Dieter Kasperkovitz, Philips Research Laboratories, Eindohen, The Netherlands.

Such a quadrature oscillation circuit generates two high frequency signals having mutually orthogonal phases by means of voltage controlled oscillators (VCO), and may be called Quadrature Voltage-Controlled Oscillator (QVCO). This QVOC is suitable to be integrated into a single semiconductor chip and has been used in BS/CS tuners of television receivers, and transceivers and receivers in wireless LAN.

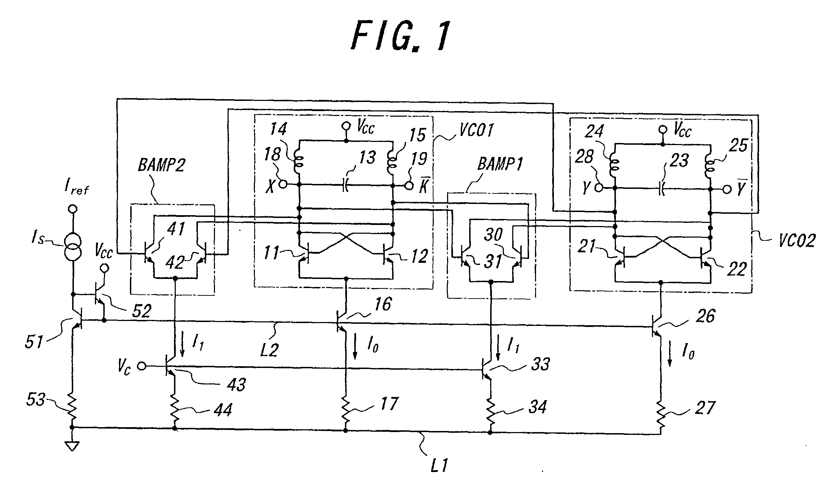

Fig. 1 is a circuit diagram showing a known QVCO. A first voltage-controlled oscillator VOC1 and a second voltage-controlled oscillator VCO2 are coupled into a ring-shape via first and second buffer amplifiers BAM1 and BAM2. The first voltage-controlled oscillator VCO1 includes a pair of transistors 11 and 12 having cross-coupled collectors and bases, and an LC resonance circuit having a capacitor 13 and coils 14, 15 is connected between the collectors of the transistors 11 and 12. A common junction between the coils 14 and 15 is connected to a power supply voltage Vcc, and commonly connected emitters of the transistors 11 and 12 are connected to a first common line L1 via an emitter-collector path of a transistor 16 and a resistor 17. The first common line L1 is connected to a reference potential such as the ground potential (GND). The collectors of the transistors 11 and 12 are connected to output terminals X and $\overline{X}$ which generate opposite phase signals, i.e. complementary signals.

The second voltage-controlled oscillator VCO2 has a same structure as the first voltage-controlled oscillator VCO1, and comprises a pair of transistors 21 and 22 having cross coupled collectors and bases. An LC resonance circuit including a capacitor 23 and coils 24 and 25 is connected between the collectors of the transistors 21 and 22. A common junction between the coils 24 and 25 is connected to the power supply voltage Vcc and a common junction of emitters of the transistors 21 and 22 is coupled to the first common line L1 by means of an emitter-collector path of a transistor 26 and a resistor 27. The collectors of the transistors 21 and 22 are connected to output terminals Y and $\overline{Y}$ which generate opposite phase signals, i.e. complementary signals. The non-inverted output high frequency signals generated from the output terminals X and Y have a mutual phase difference of 90 degrees, and the inverted output high frequency signals generated from the output terminals $\overline{X}$ and $\overline{Y}$ also have a mutual phase difference of 90 degrees.

The first buffer amplifier BAM 1 connected between the first and second voltage-controlled oscillators VCO1 and VCO2 comprises a pair of transistors 31 and 32 whose bases are connected to the collectors of the transistors 11 and 12 of the first voltage-controlled oscillator, respectively. A common junction of emitters of the transistors 31 and 32 is connected to the first common line L1 via an emitter-collector path of a transistor 33 and a resistor 34. Furthermore, collectors of the transistors 31 and 32 are connected to the collectors of the transistors 21 and 22, respectively of the second voltage-controlled oscillator VCO2.

The second buffer amplifier BAM2 includes a pair of transistors 41 and 42 whose bases are connected to the collectors of the transistors 21 and 22, respectively of the second voltage-controlled oscillator VCO2. A common junction of emitters of the transistors 41 and 42 is connected to the first common line L1 via an emitter-collector path of a transistor 43 and a resistor 44, and collectors of these transistors 41 and 42 are connected to the collectors of the transistors 11 and 12, respectively of the first voltage-controlled oscillator VCO1.

A second common line L2 connected commonly to the bases of the transistors 16 and 26 is connected to a base of the transistor 51 as well as to an emitter of a transistor 52. A base of the transistor 52 is connected to a collector of the transistor 51 and a collector of the transistor 52 is connected to the power supply voltage Vcc. The collector of the transistor 51 and the base of the transistor 52 are connected to a current source Is, and the emitter of the transistor 51 is coupled to the ground potential GND via a resistor 53.

In such QVCO, an oscillation frequency is changed by adjusting a strength of coupling between the first and second voltage-controlled oscillators VCO1 and VCO2. A strength of this coupling is defined by a ratio $I_1/I_0$ of a current $I_1$ flowing from the first and second buffer amplifiers BAMP1 and BAMP2 to a current $I_0$ flowing from the first and second voltage-controlled oscillators VCO1 and VCO2. The current $I_1$ flowing from the buffer amplifiers BAMP1 and BAMP 2 can be adjusted by changing control voltages Vc applied to the bases of these first and second buffer amplifiers. Therefore, the oscillation frequency can be adjusted by changing the control voltages Vc applied to the bases of the first and second buffer amplifiers BAMP1 and BAMP2.

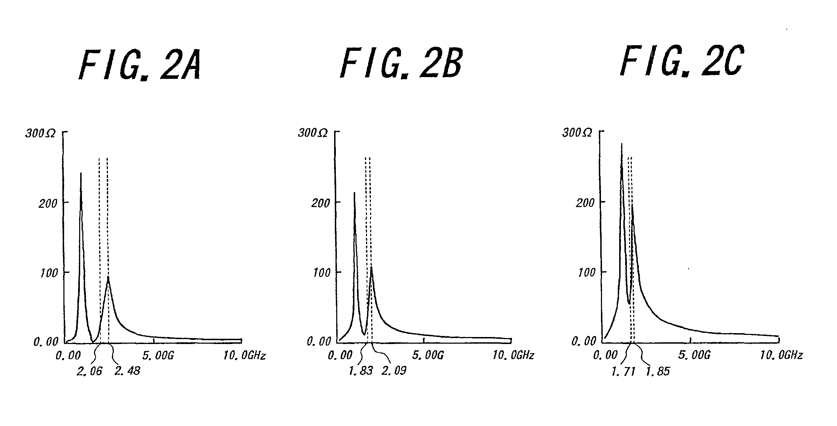

Figs. 2A-2C are graphs depicting impedance changes of the first and second voltage-controlled oscillators of the known QVCO shown in Fig. 1 when the control voltage Vc is changed. In these figures, relationships between an oscillation frequency and a resonance point are also denoted by broken lines. In the known QVCO, if $I_1=0$, only a single resonance point appears, but in practice, two resonance points appear as illustrated in the graphs, and the oscillator is liable to oscillate at a frequency which is closer to a resonance point which will be principally obtained at $I_1=0$.

Fig. 2A, 2B and 2C show simulation results of cases in which the control voltage Vc is set to 1.4 V, 1.1 V and 0.95 V, respectively. A magnitude of the current $I_1$ passing through the buffer amplifiers becomes smaller in accordance with a decrease in the control voltage Vc. In the case of Fig. 2C, the resonance frequency is about 1.83 GHz, and the circuit oscillates at an oscillation frequency of about 1.7 GHz. In the case of Fig. 2B, a resonance frequency is about 2.09 GHz and an oscillation frequency is about 1.83 GHz. In the case of Fig. 2A, a resonance frequency is about 2.48 GHz and an oscillation frequency is about 2.06 GHz. In this manner, a difference between a resonance frequency and an oscillation frequency becomes larger in accordance with an increase in the control voltage Vc. That is to say, a difference between a resonance frequency and an oscillation frequency in the cases of Figs. 2C, 2B and 2A becomes larger in this order.

As explained above, in the known oscillation circuit such as QVCO, when the control voltage Vc is low and thus the current $I_1$ flowing through the first and second buffer amplifiers BAMP1 and BAMP2 is small, i.e. when the coupling between the first and second voltage-controlled oscillators VCO1 and VCO2 is weak, an oscillation point is closer to a resonance point of the resonance circuit. However; when the current $I_1$ passing through the first and second buffer amplifiers BAMP1 and BAMP2 is large to increase an oscillation frequency, an oscillation point deviates from a resonance point accordingly. It is known that phase noise is greatly influenced by a deviation of an oscillation frequency from the resonance frequency. Therefore, phase noise is depend upon a ratio $I_1/I_0$ of the current $I_1$ flowing through the first and second buffer amplifiers BAMP1 and BAMP2 to the current $I_0$ flowing through the first and second voltage-controlled oscillators VCO1 and VCO2. When this ratio becomes larger, phase noise becomes worse accordingly.

As stated above, In the known oscillation circuit such as QVCO, phase noise fluctuates largely in accordance with an oscillation frequency within an oscillation frequency range. In order to mitigate such a problem, one may consider to increase the current $I_0$ passing through the first and second voltage-controlled oscillators VCO1 and VCO2. However, in this case, another problem occurs that the oscillation frequency range is narrowed. Therefore, in order to widen the oscillation frequency range while keeping phase noise small, it is necessary to increase the current $I_1$ flowing through the first and second buffer amplifiers BAMP1 and BAMP2. Then, power consumption is increased and phase noise might become worse as explained above. Furthermore, saturation might occur between the emitters and collectors of the transistors 11, 12, 21 and 22, and the currents $I_0$ and $I_1$ could be increased only with a limitation.

As explained above, the known oscillation circuit is subjected to conflicting problems such that when the oscillation frequency range is to be increased, phase noise becomes worse, and when phase noise is to be decreased, the oscillation frequency range is narrowed, and these problems could not be solved effectively. Furthermore, when the oscillation frequency range is to be increased, the problem of saturation between the emitter-collector of the transistor, and at the same time a power consumption is liable to be large. Such a problem might limit an application of QVCO to battery energized apparatuses.

An embodiment of the present invention may provide a novel and useful oscillation circuit, which can generate at least two high frequency signals having a same frequency and a mutual phase difference of a desired value, while phase noise is kept small over a wide oscillation frequency range without increasing power consumption as well as a manufacturing cost.

An embodiment of the invention may further provide a novel and useful quadrature oscillation circuit, which can generate two high frequency output signals having a same frequency and a mutual phase difference of 90 degrees, while phase noise can be sufficiently suppressed over a wide frequency range and power consumption can be decreased.

Preferably, an embodiment of the present invention may provide a novel and useful oscillation circuit having small phase noise and lower power consumption, which can be integrated into a single semiconductor chip.

According to the invention, an oscillation circuit comprises:

a first voltage-controlled oscillator having a resonance circuit including at least one variable capacitance element;
a second voltage-controlled oscillator having a resonance circuit including at least one variable capacitance element;
a first buffer amplifier for feeding-back a high frequency signal generated from the first voltage-controlled oscillator to the second voltage-controlled oscillator; and

a second buffer amplifier for feeding-back a high frequency signal generated from the second voltage-controlled oscillator to the first voltage-controlled oscillator;

wherein said first and second voltage-controlled oscillators generate output high frequency signals having a same frequency and a mutual phase difference of 90 degrees, and said same frequency of the output high frequency signals is controlled by adjusting a control voltage (Vc) applied to said variable capacitance elements provided in the resonance circuits of the first and second voltage-controlled oscillators.

In the oscillator circuit according to the present invention, the oscillation frequency may be adjusted not by changing a strength of coupling between the first and second voltage-controlled oscillators, but by changing the voltages applied to the first and second variable capacitance elements provided in the first and second resonance circuits of the first and second voltage-controlled oscillators, respectively. Therefore, a ratio $I_1/I_0$ of a current $I_1$ flowing from the first and second voltage-controlled oscillators to a current $I_0$ flowing from the first and second buffer amplifiers can be kept to any desired value, i.e. a minimum value required for keeping a phase difference between the high frequency signals generated from the first and second voltage-controlled oscillators to 90 degrees. Then, an oscillation frequency can be principally identical with a resonance frequency over a wide oscillation frequency range. In this case, the current $I_0$ may be as large as the transistors constituting the first and second voltage-controlled oscillators are not saturated and the current $I_1$ may be set to a small value. This results in that phase noise can be maintained small over the wide oscillation frequency range. Moreover, the current $I_1$ flowing from the first and second buffer amplifiers can be sufficiently small, and thus a power supply can be saved.

In a preferable embodiment of the oscillation circuit according to the invention, the first and second voltage-controlled oscillators as well as the first and second buffer amplifiers are integrated into a single semiconductor chip. Such a semiconductor chip can be advantageously used in portable devices, i.e. mobile products, in which lower phase noise and lower power consumption are required.

According to a second aspect of the invention, an oscillation circuit comprises:

a plurality of voltage-controlled oscillators each having a resonance circuit including at least one variable capacitance element; and
a plurality of buffer amplifier whose number is identical with said plurality of voltage-controlled oscillators, said plurality of voltage-controlled oscillators and said plurality of buffer amplifiers being alternately connected into a ring-shape such that each of said plurality of buffer amplifiers feeds-back a high frequency signal generated from a succeeding voltage-controlled oscillator to a following voltage-controlled oscillator;

wherein said plurality of voltage-controlled oscillators generate the output high frequency signals having a same frequency and a desired mutual phase difference, and said same frequency of the output high frequency signals is controlled by adjusting a control voltage applied to said variable capacitance elements provided in the resonance circuits of said plurality of voltage-controlled oscillators.

Brief Description of the drawings

Fig. 1 is a circuit diagram showing a known quadrature oscillation circuit;
Figs. 2A, 2B and 2C are graphs representing the operation of the known quadrature oscillation circuit shown in Fig. 1;
Fig. 3 is a circuit diagram illustrating a first embodiment of the oscillation circuit according to the invention;
Figs. 4A, 4B and 4C are graphs for explaining the operation of the oscillation circuit of Fig. 3;
Figs. 5A, 5B and 5C are graphs representing phase noise characteristics of the oscillation circuit according to the invention in comparison with the known oscillation circuit;
Fig. 6 is a circuit diagram showing a second embodiment of the oscillation circuit according to the invention; and
Fig. 7 is a circuit diagram depicting a third embodiment of the oscillation circuit according to the invention.

Description of the Preferred Embodiments

Now the present invention will be explained in detail with reference to embodiments shown in the accompanied drawings.

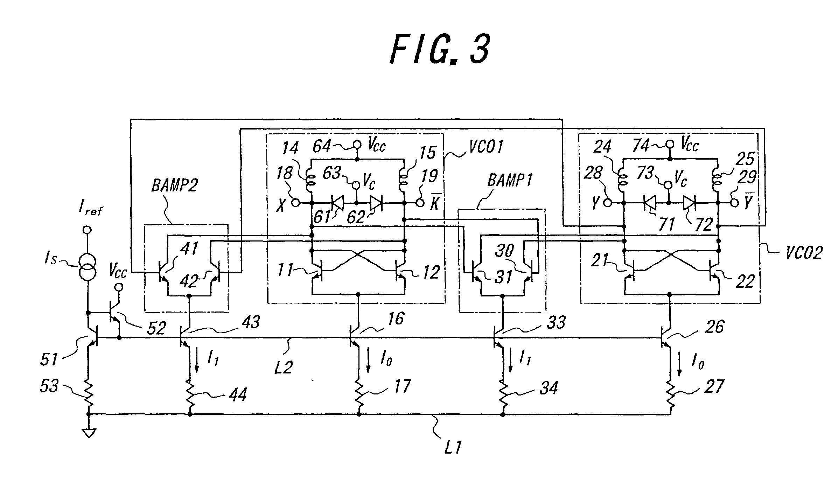

Fig. 3 is a circuit diagram showing a first embodiment of the oscillation circuit according to the invention. The oscillation circuit of the present embodiment is constructed as a quadrature oscillator which generates two high frequency signals having a phase difference of about 90 degrees. Since the structure of the oscillation circuit according to the invention as a whole is similar to that of the known oscillation circuit shown in Fig. 1, In Fig. 3, portions similar to those illustrated in Fig. 1 are denoted by the same reference numerals used in Fig. 1. In the present embodiment, a pair of varactor diodes, i.e. varicaps 61 and 62 serving as the variable capacitance element are connected in opposite polarity between collectors of transistors 11 and 12 provided in a first voltage-controlled oscillator VCO1, and commonly connected anodes of these varactor diodes are connected to a control terminal 63 to which a control voltage Vc is applied. A junction point of a pair of coils 14 and 15 is connected to a power supply voltage Vcc.

A second voltage-controlled oscillator VCO2 is constructed similarly to the first VCO1. That is to say, a pair of varactor diodes 71 and 72 are connected in opposite polarity between collectors of transistors 21 and 22 provided in the second voltage-controlled oscillator VCO2, and anodes of these varactor diodes are connected commonly to a control terminal 73 to which the control voltage Vc is applied. A junction point of a pair of coils 24 and 25 is connected to a terminal 74 to which the power supply voltage Vcc is applied.

Commonly connected emitters of paired transistors provided in the first and second voltage-controlled oscillators VCO1 and VCO2 and first and second buffer amplifiers BAMP1 and BAMP2 are connected to a first common line L1 by means of transistors 16, 26 and 33, 34 and resistors 17, 27 and 34, 44, respectively. The first common line L1 is connected to a reference potential such as the ground potential (GND). Bases of these transistors 16,26 and 33, 43 are connected to a second common line L2 which is connected to a base of a transistor 51 whose emitter-collector path is connected in series with a current source $I_s$ as well as an emitter of a transistor 52 whose collector is connected to the power supply voltage Vcc. Therefore, in the present invention, a current $I_0$ flowing through the first and second voltage-controlled oscillators VCO1 and VCO2 and a current $I_1$ flowing through the first and second buffer amplifiers BAMP1 and BAMP2 are kept to constant values.

In the present embodiment, by adjusting the control voltages Vcc applied to the control terminals 63 and 73 to be identical with each other, capacitance values of the varactor diodes 61, 62 and 71, 72 provided in the first and second voltage-controlled oscillators VCO1 and VCO2 are changed, and reactance values of the resonance circuits which are constituted by the varactor diodes 61, 62 and 71, 72 and coils 14, 15 and 24, 25, respectively and operate like as the LC resonance circuit are changed. Therefore, in the present specification, the resonance circuits are also called quasi-LC resonance circuits. Then, the oscillation frequency is changed. In this manner, the oscillation frequency becomes substantially identical with the resonance frequency at any frequency with a frequency range, and phase noise does not substantially fluctuate in accordance with oscillation frequency.

A ratio $I_1/I_0$ of the current $I_1$ flowing from the first and second buffer amplifiers BAMP1 and BAMP2 to the current $I_0$ flowing from the first and second voltage-controlled oscillators VCO1 and VCO2 is set to an optimum small value for keeping a phase difference between output signals X and Y to 90 degrees. That is to say, when the current $I_1$ is set to a smaller value and the current $I_0$ is set to a larger value, the oscillation frequency becomes substantially identical with the resonance point and phase noise can be suppressed sufficiently. In this case, the current $I_1$ flowing from the first and second buffer amplifiers BAMP1 and BAMP2 can be set to a sufficiently small value, and therefore the current $I_0$ flowing from the first and second voltage-controlled oscillators VCOI and VCO2 can be relatively large. In this manner, phase noise can be kept to a favorable low level over a wide frequency range as compared with the known oscillation circuit.

Furthermore, since the current $I_1$ flowing from the first and second buffer amplifiers BAMP1 and BAMP2 is small, it is possible to realize the quadrature oscillation circuit having a lower power consumption. In this manner, the two quadratic high frequency signals having the same frequency and a phase difference of 90 degrees are generated from the output terminals 18 and 28 or 19 and 29, while phase noise can be kept to a preferable low level over a wide frequency range.

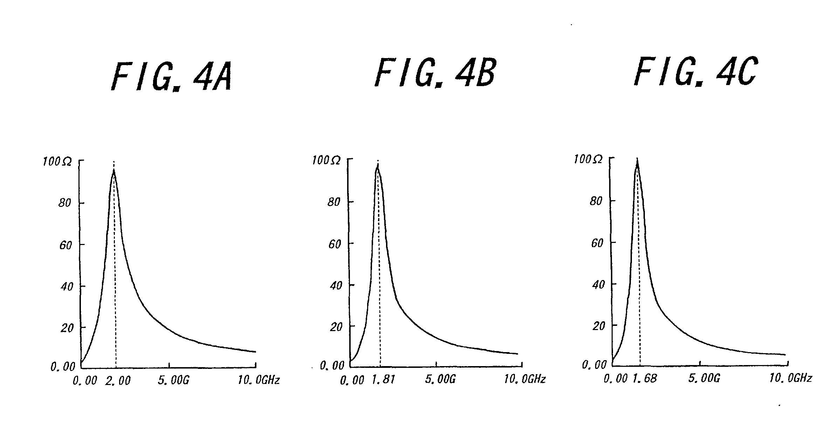

Figs. 4A, 4B and 4C show an impedance change of the first and second voltage-controlled oscillators VCO1 and VCO2 when the control voltage Vc applied to the control terminals 63 and 64 is changed to 0 V, 2 V and 2.8 V, respectively. Then, the oscillation frequency is changed to 2.00 GHz, 1.81 GHz and 1.68 GHz, respectively as shown by broken lines in Figs. 4A, 4B and 4C. It should be noted that in the present embodiment, the quadrature oscillation circuit has only a single resonance point. Since the oscillation frequency is principally identical with the resonance point, a difference of the oscillation frequency and the resonance frequency is negligible.

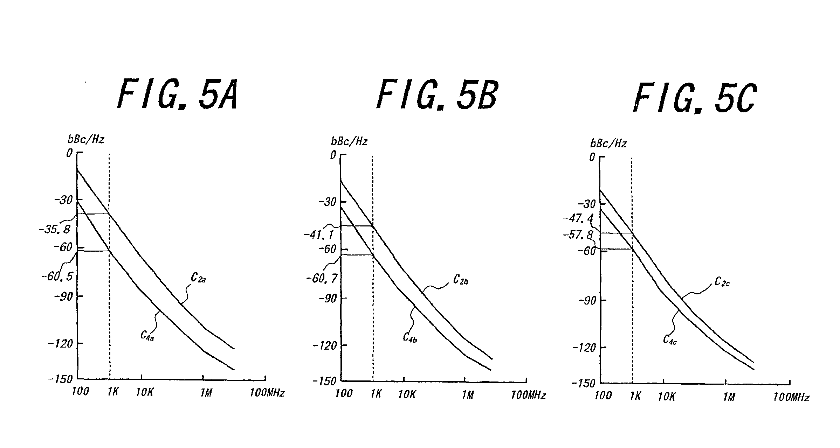

Figs. 5A, 5B and 5C a relationship between off-set frequency and phase noise at different oscillation frequencies in the quadratic oscillation circuit according to the invention shown in Fig. 3 in comparison with the known oscillation circuit illustrated in Fig. 1. Curves $C_{2a}$ and $C_{4a}$ represent phase noise characteristics of the cases shown in Figs. 2A and 4A, respectively near the oscillation frequency of 2.0 GHz. Similarly, curves $C_{2b}$ and $C_{4b}$ represent phase noise characteristics of the cases shown in Figs. 2B and 4B, respectively near the oscillation frequency of 1.8 GHz, and curves $C_{2c}$ and $C_{4c}$ represent phase noise characteristics of the cases shown in Figs. 2C and 4C, respectively near the oscillation frequency of 1.7 GHz

As represented by the curves $C_{2a}$ and $C_{4a}$ in Fig. 5A showing phase noise at the oscillation frequency of 1.8 GHz, phase noise of the known oscillation circuit at the oscillation frequency of 2.0 GHz is about -35.8 dB/Hz for the off-set frequency of 1 KHz, but in the oscillation circuit according to the invention, phase noise is sufficiently suppressed to -60.5 dB/Hz. In the oscillation circuit according to the invention, phase noise is improved also at other oscillation frequencies.

As denoted by the curves $C_{2b}$ and $C_{4b}$ shown in Fig. 5B, at the oscillation frequency of about 1.8 GHz, phase noise at an off-set frequency of 1 KHz is about -41.1 dB/Hz in the known oscillation circuit and is about -60.7 dB/Hz in the oscillation circuit according to the invention. According to the invention, phase noise is improved at other off-set frequencies as compared with the known oscillation circuit. Moreover, as illustrated by the curves $C_{2c}$ and $C_{4c}$ in Fig. 5C showing phase noise at the oscillation frequency of 1.7 GHz, phase noise at an off-set frequency of 1 KHz is about -47.4 dB/Hz in the known oscillation circuit and is about -57.8 dB/Hz in the oscillation circuit according to the invention. At another off-set frequencies, phase noise is improved in the oscillation circuit according to the present invention.

As can be understood from the curves shown in Figs. 5A-5C, in the known oscillation circuit illustrated in Fig. 1, when an oscillation frequency is changed to about 1.7 GHz, about 1.8 GHz and about 2.0 GHz, phase noise at off-set frequency of 1 KHz becomes worse such as -47.4 dB/Hz, -41.1 dB/Hz and -35.8 dB/Hz, respectively in accordance with an increase in oscillation frequency. This is due to the above mentioned fact that in the known oscillation circuit, a deviation of an oscillation frequency from a resonance point becomes larger in accordance with an increase in oscillation frequency.

It should be noted that since the currents $I_1$ flowing from the buffer amplifiers BAMP1 and BAMP2 are small, resistors having large resistance such as several kΩ may be connected between the collectors of the transistors 30 and 31 provided in the first buffer amplifier BAMP1 and the second voltage controlled oscillator VOC2 and similarly resistors having large resistance such as several kΩ may be connected between the collectors of the transistors 40 and 41 provided in the second buffer amplifier BAMP2 and the first voltage controlled oscillator VOC1. Then, an equivalent parallel resistance of the voltage controlled oscillators VCO1, VCO2 can be closer to an absolute value of an equivalent parallel resistance of a voltage controlled oscillator to which the buffer amplifier is not connected. That is to say, an equivalent parallel resistance of the voltage controlled oscillators VCO1 and VCO2 can be increased.

Similarly, since the currents $I_1$ flowing from the buffer amplifiers BAMP1 and BAMP2 are small, coils having high inductance not less than several nH may be connected between the bases of the transistors 30 and 31 provided in the first buffer amplifier BAMP1 and the second voltage controlled oscillator VOC2 and coils having high inductance not less than several nH may be connected between the bases of the transistors 40 and 41 provided in the second buffer amplifier BAMP2 and the first voltage controlled oscillator VOC1. Then, an equivalent parallel resistance of the voltage controlled oscillators VCO1, VCO2 can be increased.

In this manner, an absolute value of negative resistance of the voltage controlled oscillators VCO1 and VCO2 having the buffer amplifiers BAMP1 and BAMP2 connected thereto can be improved. Therefore, a steepness of a spectrum of output signal can be adjusted.

In the oscillation circuit according to the invention shown in Fig. 3, even when an oscillation frequency is changed to about 1.7 GHz, about 1.8 GHz and about 2.0 GHz, phase noise at an off-set frequency of 1 KHz is substantially constant such as -57.8 dB/Hz, -60.7 dB/Hz and -60.5 dB/Hz. It should be noted that phase noise is suppressed remarkably over the prior oscillation circuit. This is due to the fact that according to the invention, an oscillation frequency is principally identical with a resonance point.

In the above explanation, off-set frequency is set to 1 KHz, but the above explanation can be equally applied to other off-set frequencies. For instant, at off-set frequency of 10 KHz, phase noise is improved in the oscillation circuit according to the invention as compared with the known oscillation circuit.

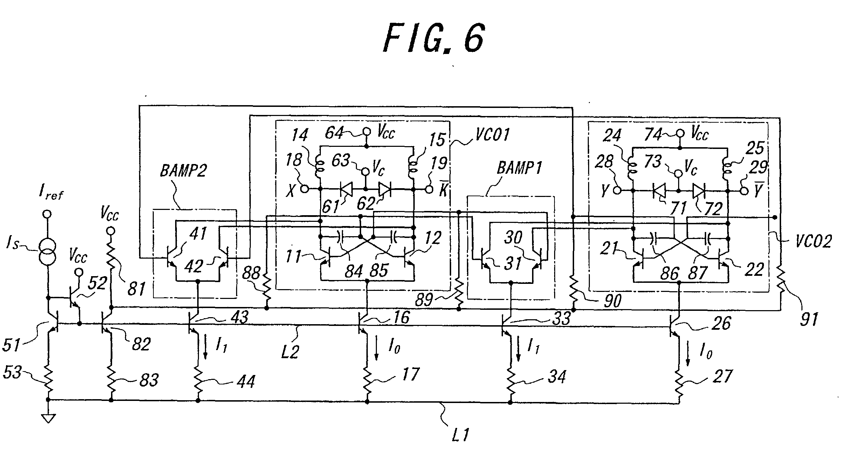

Fig. 6 is a circuit diagram illustrating a second embodiment of the oscillation circuit according to the invention. Also in the present embodiment, the oscillation circuit is constructed as the quadrature oscillation circuit. In the present embodiment, portions similar to those of the first embodiment depicted in Fig. 3 are denoted by the reference numerals used in Fig. 3 and their detailed explanation is dispensed with. In the present embodiment, a series circuit of resistor 81, transistor 82 and resistor 83 is connected across the power supply voltage Vcc and the reference potential such as the ground potential (GND), and a base of this transistor 82 is connected to the second common line L2.

In a first voltage-controlled oscillator VCO1, a capacitor 84 is connected between a collector of a transistor 11 and a base of a transistor 12, and a capacitor 85 is connected between a base of the transistor 11 and a collector of the transistor 12. Similarly, in a second voltage-controlled oscillator VCO2, a capacitor 86 is connected between a collector of a transistor 21 and a base of a transistor 22, and a capacitor 87 is connected between a base of the transistor 21 and a collector of the transistor 22.

Also in this embodiment, the currents $I_1$ flowing from the buffer amplifiers BAMP1 and BAMP2 are small, and therefore resistors having large resistance such as several kΩ may be connected between the collectors of the transistors 30 and 31 provided in the first buffer amplifier BAMP1 and the second voltage controlled oscillator VOC2 and similarly resistors having large resistance such as several kΩ maybe connected between the collectors of the transistors 40 and 41 provided in the second buffer amplifier BAMP2 and the first voltage controlled oscillator VOC1. Then, an equivalent parallel resistance of the voltage controlled oscillators VCO1, VCO2 becomes closer to an absolute value of an equivalent parallel resistance of a voltage controlled oscillator to which the buffer amplifier is not connected. That is to say, an equivalent parallel resistance of the voltage controlled oscillators VCO1 and VCO2 can be increased.

Similarly, since the currents $I_1$ flowing from the buffer amplifiers BAMP1 and BAMP2 are small, coils having high inductance not less than several nH may be connected between the bases of the transistors 30 and 31 provided in the first buffer amplifier BAMP1 and the second voltage controlled oscillator VOC2 and coils having high inductance not less than several nH may be connected between the bases of the transistors 40 and 41 provided in the second buffer amplifier BAMP2 and the first voltage controlled oscillator VOC1. Then, an equivalent parallel resistance of the whole circuit may be higher than an equivalent parallel resistance of the voltage controlled oscillators VCO1, VCO2.

In this manner, an absolute value of negative resistance of the voltage controlled oscillators VCO1 and VCO2 having the buffer amplifiers BAMP1 and BAMP2 connected thereto can be improved. Therefore, a steepness of a spectrum of output signal can be adjusted.

Furthermore, a collector of the transistor 82 is connected via a resistor 88 to a junction point between the capacitor 84 and the base of the transistor 12 and is connected via a resistor 89 to a junction point between the capacitor 85 and the base of the transistor 11. The collector of the transistor 82 is further connected via a resistor 90 to a junction point between the capacitor 86 and the base of the transistor 22 and is connected via a resistor 91 to a junction point between the capacitor 87 and the base of the transistor 21.

A junction point between the capacitor 84 and the base of the transistor 12 is connected to a base of a transistor 31 of a first buffer amplifier BAMP1, and a junction point between the capacitor 85 and the base of the transistor 11 is connected to a base of a transistor 32 of the first buffer amplifier BAMP1. Similarly, a junction point between the capacitor 86 and the base of the transistor 22 is connected to a base of a transistor 41 of a second buffer amplifier BAMP2, and a junction point between the capacitor 87 and the base of the transistor 12 is connected to a base of a transistor 42 of the second buffer amplifier BAMP2. The remaining structure of the present embodiment is similar to the first embodiment shown in Fig. 3.

In the present embodiment, the first and second voltage-controlled oscillators VCO1 and VCO2 include respective biasing circuits, and therefore these voltage-controlled oscillators can be set to optimum operating conditions. That is to say, by adjusting the base potentials of the transistors 11, 12, 21 and 22 with the aid of the biasing circuits, undesired saturation in the transistors can be avoided, and therefore phase noise can be effectively prevented from being deteriorated.

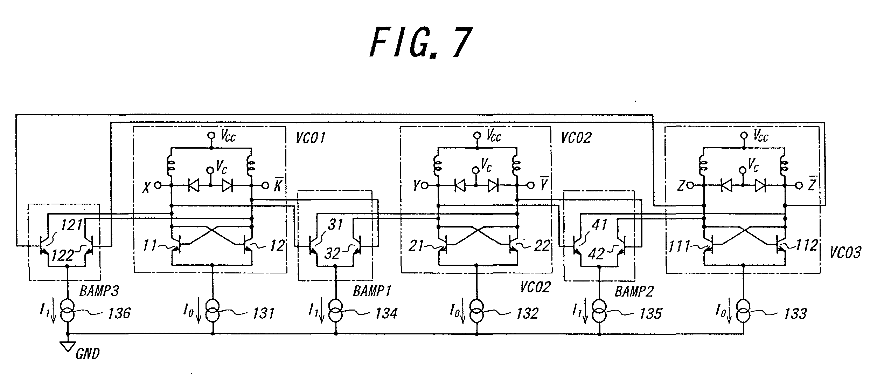

Fig. 7 is a circuit diagram showing a third embodiment of the oscillation circuit according to the invention. In the present embodiment, portions similar to those of the first embodiment depicted in Fig. 3 are denoted by the reference numerals used in Fig. 3 and their detailed explanation is dispensed with. In the present embodiment, three sets of the voltage-controlled oscillators and buffer amplifiers are provided and the voltage-controlled oscillators and buffer amplifiers are alternately connected in a ring-shape.

Bases of transistors 31 and 32 provided in a first buffer amplifier BAMP1 are connected to collectors of transistors 11 and 12, respectively provided in a first voltage-controlled oscillator VCO1, and collectors of the transistors 31 and 32 are connected to collectors of transistors 22 and 21, respectively provided in a second voltage-controlled oscillator VCO2.

Bases of transistors 41 and 42 provided in a second buffer amplifier BAMP2 are connected to collectors of the transistors 21 and 22, respectively of the second voltage-controlled oscillator VCO2, and collectors of the transistors 41 and 42 are connected to collectors of transistors 112 and 111, respectively provided in a third voltage-controlled oscillator VCO3.

Similarly, bases of transistors 121 and 122 provided in a third buffer amplifier BAMP3 are connected to collectors of the transistors 111 and 112, respectively of the third voltage-controlled oscillator VCO2, and collectors of the transistors 121 and 122 are connected to collectors of transistors 11 and 12, respectively of the first voltage-controlled oscillator VCO1.

Commonly connected emitters of a pair of transistors provided in the first, second and third voltage-controlled oscillators VCO1, VCO2 and VCO3 are coupled with a reference potential such as the ground potential (GND) by means of current sources 131, 132 and 133, respectively. From these commonly connected emitters, currents $I_0$. flow. Commonly connected emitters of a pair of transistors of the first, second and third buffer amplifiers BAMP1, BAMP2 and BAMP3 are coupled with the reference potential via current sources 134, 135 and 136. Currents $I_1$ flow from these commonly connected emitters.

In the third embodiment of the present invention, the first, second and third voltage-controlled oscillators VCO1, VCO2 and VCO3 generates output signals X, Y and Z, respectively having mutual phase differences of 60 degrees. It should be noted that reversed output signals X, Y and Z have also mutual phase difference of 60 degrees. Any of these output signals may be selected in accordance with particular applications.

In a modification of the third embodiment of the oscillation circuit according to the invention, the commonly connected emitters of a pair of transistors provided in the first, second and third voltage-controlled oscillators VCO1, VCO2 and VCO3 may be connected to the reference potential such as the ground potential (GND) via emitter-collector paths of transistors (not shown) whose bases are connected to the current sources like as the first and second embodiments. Similarly, the commonly connected emitters of a pair of transistors provided in the first, second and third buffer amplifiers BAMP1, BAMP2 and BAMP3 may be connected to the reference potential via emitter-collector paths of transistors (not shown) whose bases are connected to the current sources like as the first and second embodiments.

The present invention is not limited to the above explained embodiments, but many alternations and modifications may be conceived by a person skilled in the art within the scope of the invention. For instance, in the above embodiments, the varactor diodes provided in the resonance circuit of the voltage-controlled oscillator are connected in opposite polarity by connected their anodes each other, but according to the invention, cathodes of these varactor diodes may be connected each other. Furthermore, the varactor diode may be replaced by any other variable capacitance element such as MOS cap which is a kind of MOS transistor and whose capacitance is adjusted by changing a gate voltage. In the above embodiments, the resonance circuit of the voltage-controlled oscillator is formed by a circuit similar to the LC resonance circuit, but according to the invention, the resonance circuit may be formed by any other circuit similar to the RC resonance circuit including variable capacitance elements and resistors. Therefore, this resonance circuit is also called a quasi-RC resonance circuit. Moreover, in the above embodiments, a plurality of the voltage-controlled oscillators and a plurality of the buffer amplifiers may be integrated into a single semiconductor chip.

In the first embodiment, two sets of the voltage-controlled oscillators and two sets of the buffer amplifiers are used to generate the output high frequency signals having a mutual phase difference of 90 degrees, and in the second embodiment, three sets of the voltage-controlled oscillators and three sets of the buffer amplifiers are used to generate the output high frequency signals having a mutual phase difference of 60 degrees. According to the invention, a combination of the voltage-controlled oscillators and buffer amplifiers may be selected in a various manner in accordance with desired phase difference. For instance, output signals having a mutual phase difference of 45 degrees or 30 degrees can be easily generated.

As explained above in detail, in the oscillation circuit according to the invention, a resonance point of the voltage-controlled oscillator is changed by adjusting a voltage applied to variable capacitance element provided in the resonance circuit of the voltage-controlled oscillator, and an oscillation frequency is changed thereby. Therefore, it is no more necessary to change currents flowing through the voltage-controlled oscillators and buffer amplifiers, and a ratio of these currents can be maintained to an optimum value. Therefore, phase noise can be suppressed to a sufficiently low level over a wide frequency range. Moreover, the current flowing through the buffer amplifier can be kept low, and thus power consumption can be decreased.

**Claims**

1.　An oscillation circuit comprising:

a first voltage-controlled oscillator having a resonance circuit including at least one variable capacitance element;

a second voltage-controlled oscillator having a resonance circuit including at least one variable capacitance element;

a first buffer amplifier for feeding-back a high frequency signal generated from the first voltage-controlled oscillator to the second voltage-controlled oscillator; and

a second buffer amplifier for feeding-back a high frequency signal generated from the second voltage-controlled oscillator to the first voltage-controlled oscillator;

wherein said first and second voltage-controlled oscillators generate output high frequency signals having a same frequency and a mutual phase difference of 90 degrees, and said same frequency of the output high frequency signals is controlled by adjusting a control voltage applied to said variable capacitance elements provided in the resonance circuits of the first and second voltage-controlled oscillators.

2.　The oscillation circuit according to claim 1, wherein currents flowing from said first and second voltage-controlled oscillators and currents flowing from said first and second buffer amplifiers are fixed to such values that desired phase noise is obtained.

3.　The oscillation circuit according to claim 1, wherein each of said resonance circuits of the first and second voltage-controlled oscillators is formed by a quasi-LC resonance circuit includes at least one inductive element in addition to said at least one variable capacitive element.

4.　The oscillation circuit according to claim 1, wherein each of said resonance circuits of the first and second voltage-controlled oscillators is formed by a quasi-RC resonance circuit includes at least one resistive element in addition to said at least one variable capacitive element.

5.　The oscillation circuit according to claim 3, wherein each of said plurality of voltage-controlled oscillators comprises first and second transistors having cross coupled bases and collectors and commonly connected emitters, a pair of variable capacitance elements connected across the collectors of the first and second transistors, a pair of coils connected between the collectors of the first and second transistors, a control terminal connected to a common junction point of said pair of variable capacitance elements, a power supply terminal connected to a common junction point of said pair of coils, and first and second output terminals connected to the collectors of said first and second transistors, respectively, and each of said plurality of buffer amplifiers comprises third and fourth transistors having commonly connected emitters, whereby said control voltage is applied to said control terminal, and said first and second output terminals generate said output high frequency signal in non-inverted and inverted fashions, respectively.

6. The oscillation circuit according to claim 5, wherein said commonly connected emitters of said first and second transistors are connected to a reference potential via a series circuit of an emitter-collector path of a fifth transistor, said commonly connected emitters of the third and fourth transistors are connected to the reference potential via a series circuit of an emitter-collector path of a sixth transistor and a resistor, and bases of said fifth and sixth transistors are connected a bias voltage source having a given value.

7. The oscillation circuit according to claim 5, wherein capacitors are connected between the cross coupled bases and collectors of the first and second transistors, and common junction points between the capacitors and the bases of the first and second transistors are connected to a bias circuit via respective resistors.

8. The oscillation circuit according to claim 1, wherein said variable capacitance element is formed by a varactor diode.

9. The oscillation circuit according to claim 8, wherein each of the resonance circuits of the first and second voltage-controlled oscillators comprises a pair of varactor diodes connected in opposite polarity, and commonly connected anodes or cathodes of said pair of varactor diodes are connected to a control terminal to which said control voltage is applied.

10. The oscillation circuit according to claim 1, wherein said first and second voltage-controlled oscillators and first and second buffer amplifiers are integrated into a single semiconductor chip.

11. An oscillation circuit comprising:

a plurality of voltage-controlled oscillators each having a resonance circuit including at least one variable capacitance element; and
a plurality of buffer amplifier whose number is identical with said plurality of voltage-controlled oscillators, said plurality of voltage-controlled oscillators and said plurality of buffer amplifiers being alternately connected into a ring-shape such that each of said plurality of buffer amplifiers feeds-back a high frequency signal generated from a succeeding voltage-controlled oscillator to a following voltage-controlled oscillator;

wherein said plurality of voltage-controlled oscillators generate the output high frequency signals having a same frequency and a desired mutual phase difference, and said same frequency of the output high frequency signals is controlled by adjusting a control voltage applied to said variable capacitance elements provided in the resonance circuits of said plurality of voltage-controlled oscillators.

12. The oscillation circuit according to claim 11, wherein currents flowing from said plurality of voltage-controlled oscillators and currents flowing from said plurality of buffer amplifiers are fixed to such values that desired phase noise is obtained.

13. The oscillation circuit according to claim 11, wherein each of the resonance circuits of said plurality of voltage-controlled oscillators is formed by a quasi-LC resonance circuit includes at least one inductive element in addition to said at least one variable capacitive element.

14. The oscillation circuit according to claim 11, wherein each of said resonance circuits of the first and second voltage-controlled oscillators is formed by a quasi-RC resonance circuit includes at least one resistive element in addition to said at least one variable capacitive element.

15. The oscillation circuit according to claim 13, wherein each of said plurality of voltage-controlled oscillators comprises first and second transistors having cross coupled bases and collectors and commonly connected emitters, a pair of variable capacitance elements connected across the collectors of the first and second transistors, a pair of coils connected between the collectors of the first and second transistors, a control terminal connected to a common junction point of said pair of variable capacitance elements, a power supply terminal connected to a common junction point of said pair of coils, and first and second output terminals connected to the collectors of said first and second transistors, respectively, and each of said plurality of buffer amplifiers comprises third and fourth transistors having commonly connected emitters, whereby said control voltage is applied to said control terminal, and said first and second output terminals generate said output high frequency signal in non-inverted and inverted fashions, respectively.

16. The oscillation circuit according to claim 15, wherein said commonly connected emitters of said first and second transistors are connected to a reference potential via a series circuit of an emitter-collector path of a fifth transistor, said commonly connected emitters of the third and fourth transistors are connected to the reference potential via a series circuit of an emitter-collector path of a sixth transistor and a resistor, and bases of said fifth and sixth transistors are connected a bias voltage source having a given value.

17. The oscillation circuit according to claim 15, wherein a pair of capacitors are connected between the cross coupled bases and collectors of the first and second transistors, and common junction points between the respective capacitors and the bases of the first and second transistors are connected to a bias circuit via respective resistors.

18. The oscillation circuit according to claim 11, wherein said variable capacitance element is formed by a varactor diode.

19. The oscillation circuit according to claim 18, wherein each of the resonance circuits of said plurality of voltage-controlled oscillators comprises a pair of varactor diodes connected in opposite polarity, and commonly connected anodes or cathodes of said pair of varactor diodes are connected to a control terminal to which said control voltage is applied.

20. The oscillation circuit according to claim 11, wherein said plurality of voltage-controlled oscillators and said plurality of buffer amplifiers are integrated into a single semiconductor chip.

# FIG. 1

EP 1 225 689 A2

## FIG. 2A

300Ω

200

100

0. 00

0. 00          5. 00G          10. 0GHz

2. 06   2. 48

## FIG. 2B

300Ω

200

100

0. 00

0. 00          5. 00G          10. 0GHz

1. 83   2. 09

## FIG. 2C

300Ω

200

100

0. 00

0. 00          5. 00G          10. 0GHz

1. 71   1. 85

EP 1 225 689 A2

**FIG. 3**

FIG. 4A          FIG. 4B          FIG. 4C

EP 1 225 689 A2

FIG. 5A   FIG. 5B   FIG. 5C

# FIG. 6

EP 1 225 689 A2

# FIG. 7